# EUROPEAN PATENT APPLICATION

(11) **EP 4 447 091 A1**
(43) Date of publication of application: **16.10.2024**
(21) Application number: 22903947.4
(22) Date of filing: 08.11.2022
(51) Int. Cl.: H01L 21/304, B23K 26/53, B24B 7/22, B28D 5/04

(54) **WAFER MANUFACTURING METHOD**

(30) Priority: 08.12.2021 JP 2021199578
(71) Applicant: DENSO CORPORATION, Kariya-city, Aichi 448-8661 (JP)
(72) Inventor: YASUDA Koichiro, Kariya-city, Aichi 448-8661 (JP); TAKAGI Ryota, Kariya-city, Aichi 448-8661 (JP); KAWAZU Tomoki, Kariya-city, Aichi 448-8661 (JP); NOMURA Sodai, Kariya-city, Aichi 448-8661 (JP); SHIRAI Hideaki, Kariya-city, Aichi 448-8661 (JP); SOLTANI Bahman, Kariya-city, Aichi 448-8661 (JP); SOBAJIMA Shunsuke, Kariya-city, Aichi 448-8661 (JP)
(74) Representative: Kuhnen & Wacker Patent- und Rechtsanwaltsbüro PartG mbB
(86) International application number: PCT/JP2022/041569
(87) International publication number: WO 2023/106016

(57) **Abstract**

A wafer production method for producing a wafer from an ingot (2) oriented to have a c-axis inclined in an off-angle direction (*Dθ*) at an off-angle (*θ*) more than zero degree from a central axis (*L*) includes steps of emitting a laser beam to a top surface (21) that is one of end surfaces of the ingot opposed to each other in height direction thereof to form a separation layer (25) at a depth from the top surface of the ingot which corresponds to a thickness of the wafer, applying a physical load in a single direction to a first end (23) that is one of ends of the ingot which are opposed to each other in an off-angle direction to remove a wafer precursor (26) from the ingot at the separation layer, and planarizing a major surface of a removed object derived by separating the wafer precursor from the ingot at the separation layer, thereby forming a wafer. The ingot has a given degree of transmittance to the laser beam. The wafer precursor is created by a portion of the ingot between the top surface of the ingot and the separation layer.

## Description

### CROSS REFERENCE TO RELATED DOCUMENT

The present application claims the benefit of priority of Japanese Patent Application No. 2021-199578 filed on December 8, 2021, the disclosure of which is incorporated in its entirety herein by reference.

### Technical Field

This disclosure relates generally to a wafer production method.

### Background of Art

Japanese Patent No. 6391471 teaches a wafer production method for producing a wafer from an ingot in an efficient way. Specifically, the wafer production method includes a release start point developing step and a wafer slicing step. The release start point developing step is to create a focus point on which a laser beam converges at a depth from an outer surface of the ingot which corresponds to a target thickness of the wafer. The ingot is made from hexagonal single crystal. The laser beam has a wavelength to which the ingot is transparent. The release start point developing step works to emit the laser beam to the ingot while moving the focus point and the ingot relative to each other, thereby creating a modified or reformed layer extending parallel to the surface of the ingot and cracking growing from the reformed layer along a C-surface (also called a C-plane) of the ingot to develop a release start point. Subsequently, the ingot is immersed in water. Ultrasonic vibration is applied to the ingot to release or separate a plate-like object from the ingot.

### PRIOR ART DOCUMENT

### PATENT LITERATURE

FIRST PATENT LITERATURE : Japanese Patent No. 6391471

### SUMMARY OF THE INVENTION

The wafer production method taught in Japanese Patent No. 6391471 produces a variation in release location where the plate-like object is sliced or removed from the ingot in a height direction of the ingot when cleavage is being induced. This may lead to a risk that the plate-like object which has been removed from the ingot may have a rough surface requiring an increased grinding or polishing allowance, or result in a failure in release of the plate-like from the ingot.

This disclosure was made in view of the above problem. It is, therefore, an object of this disclosure to provide a wafer production method which is higher in production efficiency than that in prior art methods.

According to one aspect of this disclosure, there is provided a wafer production method for producing a wafer from an ingot which comprises: (a) a separation layer formation step of emitting a laser beam to one of end surfaces of the ingot opposed to each other in height direction of the ingot to form a separation layer at a depth from the end surface of the ingot which corresponds to a thickness of the wafer, the ingot having a given degree of transmittance to the laser beam; (b) a wafer separation step of separating a wafer precursor from the ingot at the separation layer, the wafer precursor being created by a portion of the ingot between the end surface of the ingot and the separation layer; and (c) a wafer flattening step of planarizing a major surface of a plate-like removed object derived in the wafer separation step. The ingot has a c-axis oriented to be inclined in an off-angle direction at an off-angle from a central axis which is defined to extend perpendicular to the end surface of the ingot. The off-angle is selected to be more than zero degree. The separation of the wafer precursor from the ingot is achieved by applying a physical load in a single direction to an end of the ingot facing in the off-angle direction.

The above wafer production method is, as described above, to emit the laser beam to the end surface of the ingot which faces in the height direction of the ingot to create the separation layer at a depth from the end surface of the ingot which corresponds to a target thickness of the wafer, release the wafer precursor, as formed by a portion of the ingot between the end surface and the separation layer, from the ingot at the separation layer, and then planarize a major surface of the removed object derived by slicing the wafer precursor from the ingot to complete the wafer.

The above-described wafer production method works to exert the physical load in the single direction on the end of the ingot which faces in the off-angle direction to split the wafer precursor from the ingot at the separation layer. In other wors, the physical load is converged on an end of the separation layer which faces the off-angle direction, thereby forming cracking in the end of the ingot. This induces the separation of the wafer precursor at the cracking. It is, therefore, possible to ensure the stability in splitting the ingot at the whole of the separation layer using a decreased physical load applied to the ingot, thereby minimizing the roughness of a separated surface of the wafer precursor, which enables a large processing margin for grinding or polishing the wafer precursor or the ingot to be reduced. The wafer production method is, therefore, capable of providing a higher production efficiency than in the prior art production methods.

In this disclosure, reference numbers or symbols in brackets only represent correspondence relations to elements discussed in an embodiment or modifications, as described below. This disclosure is, therefore, not limited to the elements denoted by the reference numbers or symbols.

### BRIEF DESCRIPTION OF THE DRAWINGS

Fig. 1 is a side view which schematically illustrates structures of a wafer, an ingot, and a removed object in a wafer production method according to an embodiment in this disclosure.
Fig. 2 is a process chart which a sequence of steps of a wafer production method according to an embodiment of this disclosure.
Fig. 3A is a side view which schematically illustrates a structure of an ingot after a separation layer formation step is completed.
Fig. 3B is a plan view of the ingot illustrated in Fig. 3A.
Fig. 4A is a side view which schematically illustrates a separation layer formation step shown in Fig. 2 and a separation layer forming machine used in the separation layer formation step.
Fig. 4B is a front view which schematically illustrates a separation layer formation step shown in Fig. 2 and a separation layer forming machine used in the separation layer formation step.
Fig. 5A is an enlarged plan view which schematically illustrates the separation layer formation step shown in Figs. 4A and 4B.
Fig. 5B is an enlarged view which illustrates a region around a focus point developed in the separation laser formation step shown in Figs. 4A and 4B.
Fig. 6 is a plan view which schematically illustrates the separation laser formation step shown in Figs. 4A and 4B.
Fig. 7 is an enlarged view which illustrates a region around a focus on which a laser beam shown in Figs. 4A and 4B converges.
Fig. 8A is a side view which schematically illustrates the separation layer formation step shown in Fig. 4A.
Fig. 8B is a side view which schematically illustrates a modified form of a separation layer formation step.
Fig. 9 is a side view which schematically illustrates the separation layer formation step shown in Fig. 4A.
Fig. 10 is a plan view which schematically illustrates the separation layer formation step shown in Fig. 4A.
Fig. 11 is a side view which schematically illustrates a wafer separation step shown in Fig. 2 and a separating machine used in the wafer separation step.
Fig. 12 is a view which schematically illustrates a modified form of a separating machine and a wafer separation step using the separating machine.
Fig. 13 is a partial sectional side view which schematically illustrates a modified form of a wafer separation step.
Fig. 14 is a process chart which schematically illustrates a modified form of a wafer separation step.
Fig. 15A is a side view which schematically illustrates a modified form of a wafer separation step.
Fig. 15B is a side view which schematically illustrates a modified form of wafer separation step.
Fig. 15C is a side view which schematically illustrates a modified form of wafer separation step.
Fig. 15D is a side view which schematically illustrates a modified form of a wafer separation step.
Fig. 15E is a side view which schematically illustrates a modified form of wafer separation step.
Fig. 15F is a side view which schematically illustrates a modified form of wafer separation step.
Fig. 15G is a side view which schematically illustrates a modified form of wafer separation step.
Fig. 15H is a side view which schematically illustrates a modified form of wafer separation step.
Fig. 16 is a plan view which schematically illustrates a modified form of a wafer separation step.

### MODE FOR CARRYING OUT THE INVENTION

### EMBODIMENT

An embodiment of this disclosure will be described below with reference to the drawings.

### STRUCTURES OF WAFER AND INGOT

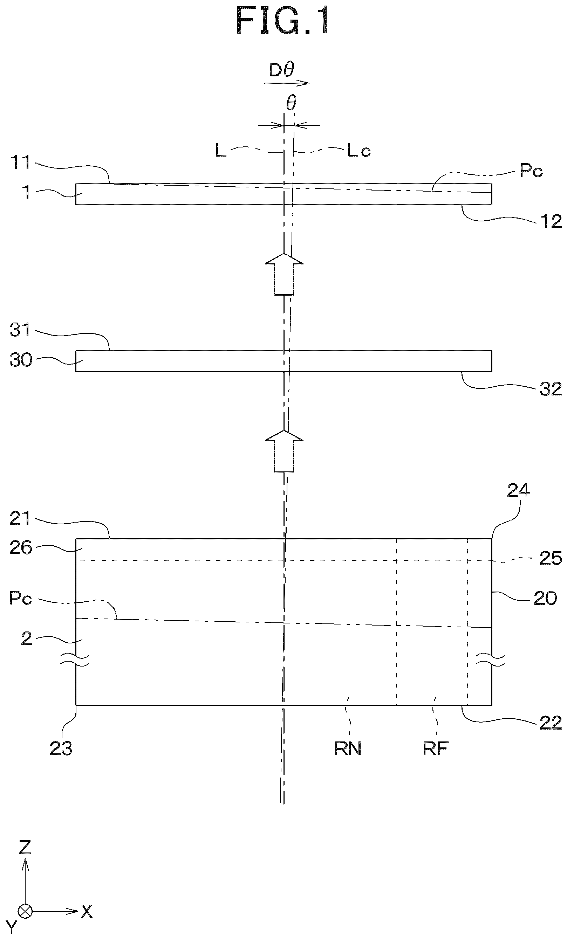

Referring to Fig. 1, the wafer 1 which is made using a wafer production method according to this embodiment is formed by laterally slicing the cylindrical ingot 2 into thin discs each of which is substantially of a circular shape in a plan view. The wafer 1 or the ingot 2 is, therefore, shaped to have a cylindrical peripheral surface (i.e., side or lateral surface) around the central axis *L.* The central axis *L* is a virtual straight line defined to extend parallel to the cylindrical side surface of the wafer 1 or the ingot 2 and pass through the axial center of the wafer 1 or the ingot 2. For the sake of simplicity in this disclosure, the explanation or illustration of the so-called orientation flat which is usually provided on the wafer 1 or the ingot 2 will be omitted here.

The ingot 2 is a single-crystal *SiC* ingot having a *c*-axis *Lc* and a (0001) surface *Pc*. The ingot 2 also has an off-angle *θ* of more than zero degree. The c-axis *Lc* is a crystal axis defined by a direction index notated as (0001). The (0001) surface *Pc* is a crystal surface extending orthogonally to the c-axis *Lc* and defined as a *c*-plane in crystallography. The off-angle *θ* is an angle which the central axis *L* of the wafer 1 or the ingot 2 makes with the c-axis *Lc* and usually in a range of 1 to 4 degrees. In other words, the c-axis *Lc* of the wafer 1 or the ingot 2 is oriented to be inclined or slant at the off-angle *θ* from the central axis *L* in the off-angle direction *Dθ.* The off-angle *θ* is selected to be greater than zero degrees. The off-angle direction *Dθ*, as referred to herein, is defined as a direction in which a point, as defined on the central axis *L* above a laser-exposed surface (i.e., an upper surface, as viewed in the drawings) of the wafer 1 or the ingot 2, advances when the central axis *L* is rotated toward the *c*-axis *Lc* about the center that is an intersection between the central axis *L* and the c-axis *Lc.* The off-angle direction *Dθ* coincides with the above direction projected onto the laser-exposed surface of the wafer 1 or the ingot 2.

For the sake of simplicity in the following discussion, a right-handed *X-Y-Z* coordinate system is defined in a way demonstrated in Fig. 1. In the right-handed *X-Y-Z* coordinate system, the off-angle direction *Dθ* coincides with the positive x-axis direction. The x-axis and the *y*-axis in the right-handed *X-Y-Z* coordinate system are defined to extend parallel to a major surface of the wafer 1 or the ingot 2. The major surface, as referred to herein, is an outer surface of a plate-like object which extends perpendicular to a thickness direction of the plate-like object. The major surface is usually also referred to as a top surface, a bottom surface, or a plate surface. In case of a cylinder, such as the cylindrical ingot 2, the major surface is an outer surface extending perpendicular to a central axis or a height-wise direction of the cylinder and defined as a top surface of a bottom surface of the cylinder. If it is required to refer to the location of the top surface or the bottom surface of an object in a vertical direction, that is, a direction in which the force of gravity acts on the object, the major surface is also referred to as an upper surface or a lower surface. The upper surface is one of a vertically-opposed surfaces of the object which faces in a direction opposite the direction in which the force of gravity acts on the object. The lower surface is one of the vertically-opposed surfaces of the object which faces away from the upper surface. In this discussion, the thickness direction of the wafer 1 and the height direction (i.e., longitudinal direction) of the ingot 2 extend parallel to the z-axis of the right-handed *X-Y-Z* coordinate system. A direction defined to extend orthogonally to the z-axis will also be referred to an in-plane direction.

The wafer 1 has the wafer *C*-surface (also called *C*-plane) 11 and the wafer *Si*-surface 12 that are a pair of opposed major surfaces. In this embodiment, the wafer 1 is oriented to have the wafer *C*-surface 11 (i.e., the top surface) which is inclined at the off-angle *θ* to the (0001) surface *Pc*. Similarly, the ingot 2 has the substantially cylindrical ingot-side surface 20, the ingot *C*-surface 21, and the ingot Si-surface 22. The ingot *C*-surface 21 and the ingot *Si*-surface 22 define a pair of major surfaces of the ingot 2. The ingot *C*-surface 21 also define a top surface of the ingot 2 which is inclined at the off-angle *θ* to the (0001) surface *Pc*. In the following discussion, an end or upstream end of the ingot 2, as viewed in cross section thereof, which faces in the off-angle direction *Dθ* will also be referred to as the first end 23. Similarly, an end or downstream end of the ingot 2 which faces away from the off-angle direction *Dθ* will also be referred to as the second end 24. In Fig. 1, the wafer *C*-surface 11 and the ingot *C*-surface 21 are oriented to extend in the positive z-axis direction.

The ingot 2 has the facet area *RF* which will simply be referred to as a facet. The ingot 2 also has the non-facet area *RN* occupying a portion thereof other than the facet area *RF*. The non-facet area *RN* will also simply be referred to as a non-facet.

### SUMMARY OF WAFER PRODUCTION METHOD

The wafer production method in this embodiment is to make the wafer 1 by the ingot 2 and includes following processes or steps.

### 1) SEPARATION LAYER FORMATION STEP

The separation layer 25 serving as a release layer is formed by emitting a laser beam onto the ingot C-surface 21 that is one of the major surfaces of the ingot 2 which are opposed to each other in the height direction of the ingot 2. The ingot 2 has a given degree of transmittance which absorbs energy of a laser beam in the ingot 2. The separation layer 25 is located at a depth from the ingot *C*-surface 21 which is substantially identical with a required thickness of the wafer 1. A "given degree of transmittance", as referred to herein, represents that it is possible to create a focus point on which a laser beam converges at a depth of the ingot 2 which corresponds to the required thickness of the wafer 1. A "depth corresponding to the required thickness of the wafer 1", as referred to herein, is a dimension expressed by the sum of a target thickness of the wafer 1 after being completed and a given amount of machining allowance removed in a wafer flattening step, as will be described later in detail, and will also be simply referred to as "depth corresponding to the thickness of the wafer 1".

### 2) WAFER SEPARATION STEP

The wafer precursor 26 which is defined by a portion of the ingot 2 between the ingot *C*-surface 21 that is a surface exposed to a laser and the separation layer 25 is released or separated at the separation layer 25 from the ingot 2. Note that a plate-like object which is formed by slicing or removing the wafer precursor 26 from the ingot 2 is commonly called a wafer, however, it is referred to in this disclosure as the removed object 30 in order to discriminate the plate-like object from the wafer 1 that is a final product produced as an epi-ready wafer with the mirrored major surfaces. The removed object 30 has a pair of opposed major surfaces: the non-separated surface 31 and the separated surface 32. The non-separated surface 31 is a surface of the ingot 2 which faces away from the separation layer 25 before the wafer separation step is performed, in other words, corresponds to the ingot C-surface 21 before the separation layer formation step and the wafer separation step are performed. The separated surface 32 serves as the separation layer 25 before the wafer separation step is performed and is created by the wafer separation step. The separated surface 32 has irregularities which arise from removal of the separation layer 25 from the ingot 2 in the wafer separation step and are required to be ground or polished.

### 3) WAFER FLATTENING STEP

At least one of the major surfaces (i.e., the non-separated surface 31 and the separated surface 32) of the removed object 30: the separated surface 32 in this embodiment is planarized or flattened to complete the wafer 1. In the wafer flattening step, *ECMG* (Electro-Chemical Mechanical Grinding) or *ECMP* (Electro-Chemical Mechanical Polishing) techniques may be used in addition to typical grinding or *CMP* (Chemical Mechanical Polishing) techniques. The wafer flattening step may include a single planarizing process or a combination of planarizing processes.

### 4) INGOT FLATTENING STEP

The top surface of the ingot 2, i.e., the ingot *C*-surface 21 which is newly created upon removal of the wafer precursor 26 from the ingot 2 is planarized or mirrored so that it can be subjected to a subsequent cycle of the separation layer formation step. In the ingot flattening step, the *ECMG* or the *ECMP* techniques may also be used in addition to typical grinding or *CMP* techniques. The ingot flattening step may include a single planarizing process or a combination of planarizing processes.

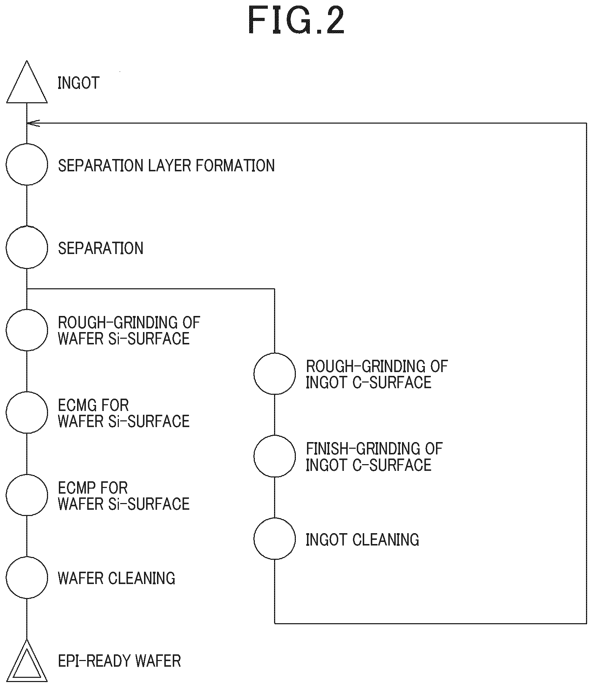

Fig. 2 is an operation flow chart which demonstrates a sequence of steps of the wafer production method in this embodiment. The removed object 30 which is separated from the ingot 2 through the separation layer formation step and the wafer separation step is subjected to the following steps to complete the epi-ready wafer 1.
*Rough grinding step* in which the separated surface 32 is subjected to rough-grinding to form the wafer *Si*-surface 12.
*ECMG step* in which the roughly-ground separated surface 32 is subjected to *ECMG.*
*ECMP step* in which the *ECMG*-subjected separated surface 32 undergoes *ECMP.*

### Cleaning step

The ingot 2 from which the removed object 30 is separated through the separation layer formation step and the wafer separation step is subjected to the following steps and then undergoes the separation layer formation step again.
*Rough grinding step* in which the ingot *C*-surface 21 created by the wafer separation step is subjected to rough-grinding.
*Finishing step* in which after subjected to rough-grinding, the ingot *C*-surface 21 is finished.

### Cleaning step

Each of the above steps will also be discussed in detail with reference to the drawings in addition to Figs. 1 and 2.

### SEPARATION LAYER FORMATION STEP

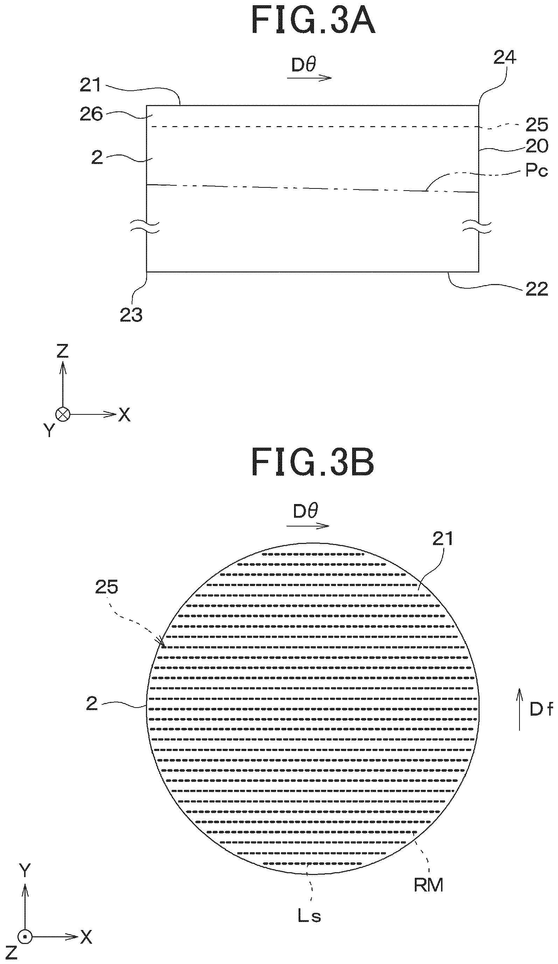

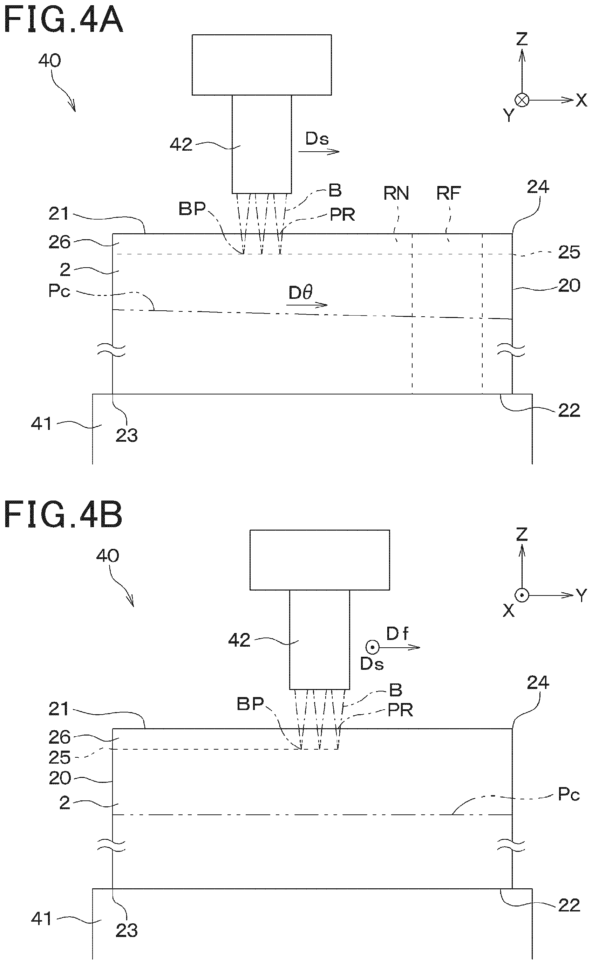

Figs. 3A and 3B illustrate a schematic structure of the ingot 2 with the separation layer 25 and the wafer precursor 26 created by the separation layer formation step. Figs. 4A and 4B illustrate the separation layer formation step and a schematic structure of the separation layer-forming machine 40 used in the separation layer formation step. The right-handed X-*Y-Z* coordinate system in each of Figs. 3A and 4B is illustrated as matching that in Fig. 1.

Referring to Figs. 3A and 3B, the separation layer 25 is created by forming a plurality of scan lines *Ls* defined by engraved marks or notches which are produced by exposure to laser beams and extend along the x-axis in the *X-Y-Z* coordinate system. Specifically, the scan lines *Ls* are, as clearly illustrated in Fig. 3B, created by the linear engraved marks (which will be referred to as laser notches *RM*) in the ingot 2. In this embodiment, the scan lines *Ls* are oriented to extend in the off-angle direction *Dθ.* The scan lines *Ls* are also arranged adjacent to each other in the line feed direction *Df.* The line feed direction *Df* is an in-plane direction orthogonal to the off-angle direction *Dθ.* In other words, the line feed direction *Df* is a direction perpendicular both to the off-angle direction *Dθ* and to the height direction of the ingot 2.

Referring to Figs. 4A and 4B, the separation layer-forming machine 40 includes the chuck table 41 and the light-concentrating device 42. The chuck table 41 firmly holds the ingot 2 at the ingot Si-surface 22 that is the bottom of the ingot 2. Specifically, the chuck table 41 is equipped with a vacuum mechanism to hold the ingot Si-surface 22 using air pressure. The holding of the ingot 2 on the chuck table 41 may alternatively be achieved in another way. The light-concentrating device 42 works to emit laser beams *B*, as generated by a pulse-lasing device, not shown, onto a target processing object, i.e., the ingot 2. Specifically, the light-concentrating device 42 is configured to create the focal points *BP* of the laser beams *B* at a depth of the ingot 2 from the ingot *C*-surface 21 which corresponds to a thickness of the wafer 1. In other words, the light-concentrating device 42 emits the laser beams *B* to the ingot 2 from above the ingot *C*-surface 21 that is the top surface of the ingot 2. The separation layer-forming machine 40 is capable of moving the focal points *BP* of the laser beams *B* relative to the ingot 2 at least in an in-plane direction, that is, the *x-y* direction in the drawings. The in-plane direction, as referred to herein, is a direction parallel to the ingot *C-*surface 21 of the ingot 2.

The separation layer-forming machine 40 sweeps the laser beams *B* in the scan direction *Ds* (which will also be referred to as a first direction) on the ingot *C*-surface 21 to form the scan lines *Ls* extending in the scan direction *Ds*. Specifically, the separation layer-forming machine 40 works to emit the laser beams *B* onto the ingot *C*-surface 21 and sweep the laser beams to move the laser exposure positions *PR* where portions of the ingot *C-*surface 21 are irradiated with the laser beams *B* in the scan direction *Ds*. In this embodiment, the scan direction *Ds* is oriented parallel to the off-angle direction *Dθ.* Specifically, the scan direction *Ds* may be the same direction as or opposite to the off-angle direction *Dθ.* The separation layer-forming machine 40 sweeps the laser beams *B* to form some of the scan lines *Ls* and then steers the laser beams *B* in the line feed direction *Df* (which will also be referred to as a second direction). Such a laser scanning operation is performed several times to create all of the scan lines *Ls* arranged adjacent to each other in the line feed direction *Df,* thereby forming the separation layer 25. The line feed direction *Df* and the scan direction *Ds* are both oriented in the in-plane direction (i.e., along the ingot *C*-surface 21) and orthogonal to each other.

More specifically, the separation layer-forming machine 40 in this embodiment works to move the chuck table 41 on which the ingot 2 is placed relative to the light-concentrating device 42 in the scan direction *Ds* to scan the ingot *C*-surface 21 with the laser beams *B* to create the scan lines *Ls* extending in the scan direction *Ds*. After the laser scan is performed in a first scanning cycle, the separation layer-forming machine 40 moves the chuck table 41 by a predetermined distance relative to the light-concentrating device 42 in the line feed direction *Df* and then moves the chuck table 41 relative to the light-concentrating device 42 again in the scan direction *Ds* (i.e., in the same direction as that in the first scanning cycle or in a direction opposite that in the first scanning cycle) to sweep the laser beams *B* to create following some of the scan lines *Ls* in a second scanning cycle. In this way, the separation layer-forming machine 40 performs laser scans using the laser beams *B* to produce all the scan lines *Ls* arranged adjacent each other in the line feed direction *Df*, thereby creating the separation layer 25. The wafer precursor 26 is also formed which will be the wafer 1 in a subsequent machining step and is located closer to the ingot C-surface 21 than the separation layer 25 is. In this embodiment, the light-concentrating device 42 is, as apparent from the above discussion, held from being moved in the in-plane direction, while the chuck table 41 which retains the ingot 2 thereon is movable at least in the in-plane direction using a scanning device, such as an electrical stage device, not shown, but however, the chuck table 41 may be fixed to be stationary, while the light-concentrating device 42 may be designed to be movable in the in-plane direction using a scanning device, not shown. In either case, the laser beams *B* and the laser exposure positions *PR* are viewed to travel on the surface of the ingot 2 in the in-plane direction. Similarly, the laser beams *B* and the focal points *BP* are viewed to travel in the in-plane direction in the ingot 2. Therefore, for the sake of simplicity, the following discussion will refer to the laser beams *B* and the laser exposure positions *PR* as moving on the surface of the ingot 2 in the in-plane direction or the laser beams *B* and the focal points *BP* as moving inside the ingot 2 in the in-plane direction, but however, this disclosure is not limited to the above arrangements.

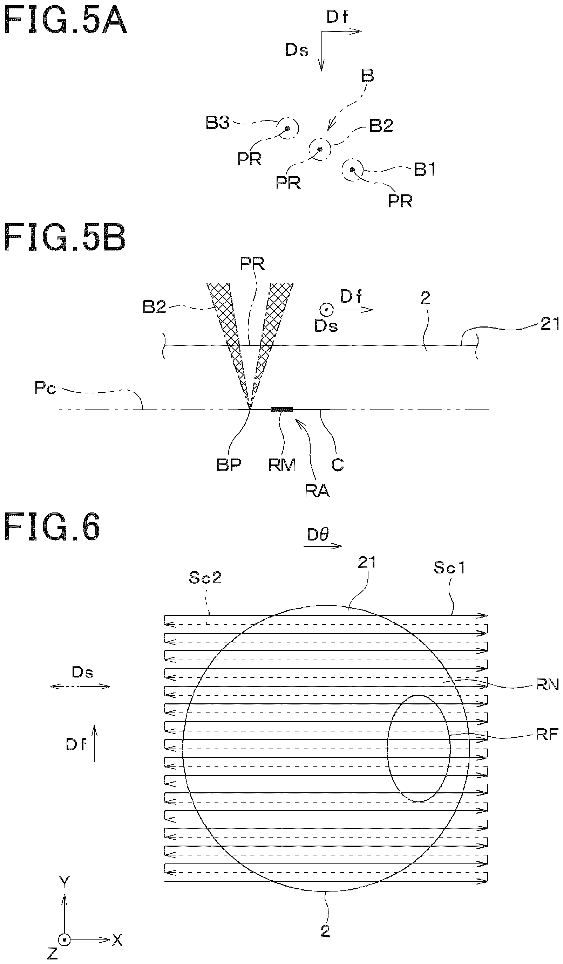

The separation layer-forming machine 40 in this embodiment is, as can be seen in Figs. 4A and 4B, designed to emit a plurality of laser beams *B* onto the ingot *C*-surface 21 in one scanning cycle. The laser beams *B* emitted in one scanning cycle are different in the laser exposure positions *RP* from each other both in the scan direction *Ds* and in the line feed direction *Df.* Specifically, the laser beams *B* which are, as can be seen in Fig. 5A, arranged diagonally away from each other to develop the laser exposure positions *PR* shifted away from each other both in the scan direction *Ds* and in the line feed direction *Df* in a plan view of the ingot *C*-surface 21 are emitted onto the ingot *C*-surface 21 and moved in the scan direction *Ds*, thereby producing the plurality of scan lines *Ls* in each scanning cycle. This results in a decreased time required to complete cyclic scanning operations in the separation layer formation step.

Figs. 4A, 4B, and 5A demonstrate an example where three laser beams *B* are used for the sake of simplicity of illustration. The number of laser beams *B* used is, therefore, optional. For convenience, the following discussion will refer to three laser beams *B:* the first beam *B1*, the second beam *B2,* and the third beams *B3*. The first beam *B1* is at the front of an array of the first beam *B1*, the second beam *B2,* and the third beam *B3* in the scan direction *Ds*, while the third beam B3 is at the tail of the array of the first beam *B1*, the second beam *B2,* and the third beam *B3* in the scan direction *Ds*. The second beam *B2* is located between the first beam *B1* and the third beam *B3*, as viewed both in the scan direction *Ds* and in the line feed direction *Df.*

The first beam *B1*, as can be seen in Fig. 5A, precedes the second beam *B2* and moves in the scan direction *Ds*. Fig. 5B illustrates emission of the second beam *B2* near the laser notch RM created by the first beam *B1.* Specifically, the emission of the first beam *B1*, as can be seen in Fig. 5B, results in a laser exposure-reacted region *RA* created at a given depth of the ingot 2. The laser exposure-reacted region *RA* includes the laser notch *RM* and the cracking *C*. The laser notch *RM* is a reformed region (i.e., also called a modified region) where *SiC* is dissociated into *Si* and *C* due to exposure to the laser beam *B*. The cracking *C* extends from the laser notch *RM* along the (0001) surface *Pc*. The laser exposure position *PR* of the second beam *B2*, therefore, may overlap the cracking *C* in the laser exposure-reacted region *RA* produced by the preceding first beam *B1* in the in-plane direction. The overlap of the laser notch *RM* or the cracking *C* contained in the laser exposure-reacted region *RA* produced by the preceding first beam *B1* with the laser exposure position *PR* of the second beam *B2* following the first beam *B1* will result in an increase in absorptance of the laser exposure-reacted region *RA* in absorbing the second beam *B2*. This facilitates the ease with which the laser notch *RM* is created by the second beam *B2* at substantially the same depth as that of the laser exposure-reacted region *RA* produced by the first beam *B1.* The same applies to a relation between the second beam *B2* and the third beam *B3.* A single sweep of the first beam *B1*, the second beam *B2,* and the third beam *B3* in each scanning operation, therefore, results in creation of the three laser notches *RM* or the three laser exposure-reacted regions *RA* which are adjacent to each other in the line feed direction *Df* and lie at substantially the same depth. This causes the scan lines *Ls* which define the separation layer 25 to be developed adjacent to each other in the line feed direction *Df* at the same depth.

The above scanning operation minimizes a variation in depth of the laser notches *RM*, i.e., the scan lines *Ls* which define the separation layer 25. This reduces the height or size of the irregularities on the separated surface 32 created by removal of the separation layer 25 from the body of the ingot 2, thereby resulting in a decrease in grinding or polishing allowance required for the separated surface 32 or defect caused by the removal of the separation layer 25 and also shortening a cycle time it takes to form or complete the separation layer 25. This embodiment is, therefore, capable of enhancing the efficiency in producing the wafer 1.

Fig. 6 demonstrates a locus of movement the center of the light-concentrating device 42 relative to the ingot 2 in the in-plane direction. The "center of the light-concentrating device 42 in the in-plane direction", as referred to herein, represents the center of the array of the laser beams *B*. In this embodiment, the ingot 2 is, as can be seen in Fig. 4A or 6, oriented to have the facet area *RF* located close to a lower side of the off-angle *θ*. The laser beams *B* are emitted from outside the ingot *C*-surface 21 onto the ingot 2 (which will also be referred to blow as *C*-surface laser emission) in the separation layer formation step. The "lower side of the off-angle", as referred to herein, represents a low height side (i.e., the right side in Fig. 4A) of the slope of the *C*-surface (i.e., the (0001) surface *Pc*) of the ingot 2, as oriented to have the ingot *C*-surface 21 facing upward, while the "higher side of the off-angle" represents a high height side of the slope of the *C*-surface of the ingot 2, as oriented to have the ingot *C*-surface 21 facing upward.

Desirable wafer removal is, as will be described below in detail, achieved by exerting a mechanical load on an end of the ingot 2 located at the higher side of the off-angle to separate the wafer precursor 26 from the ingot 2. Next, we will study a comparative example where the ingot 2 is oriented to have the facet area *RF* locate at the higher side of the off-angle, and the laser beams *B* are emitted onto the ingot 2 from outside the ingot *Si*-surface 22 (i.e., *Si*-surface lase emission), after which a mechanical load is exerted onto an end of the ingot 2 located at the higher side of the off-angle. An end portion of the ingot 2 which is located in the vicinity of the facet area *RF* usually has a great resistance to cracking. In the comparative example, the end portion of the ingot 2 which has a great resistance to cracking and is located close to the facet area *RF* will be where the wafer precursor 26 is initially separated from the ingot 2 (which will also be referred to as a release start position), thereby leading to a decreased probability of success of the wafer separation step. In order to increase the success rate, this embodiment is designed to orient the ingot 2 to have the facet area *RF* located at the lower side of the off-angle, emit the laser beams *B* onto the ingot *C*-surface 21, and then exert a mechanical load or pressure on the end portion of the ingot 2 which is located at the higher side of the off-angle. The release start position will, therefore, lie at a portion of the ingot 2 which is located far away from the facet area *RF* and has a less resistance to cracking, thereby resulting in an increased success rate of the wafer separation step.

It is known that the intensity of the laser beam *B* reaching the focal point *BP* is higher in the non-facet area *RN* than in the facet area *RF*. This embodiment is, therefore, designed to emit the laser beams *B* to the major surface of the ingot 2 in the separation layer formation step so that the density of energy of the laser beams *B* applied to the facet area *RF* will be higher than that to the non-facet area *RN.* The "applied energy density", as referred to herein, represents the density of energy in a plane extending along the major surface of the ingot 2. For instance, the output power of the laser beams *B* reaching the facet area *RF* may be increased to be higher than that of the laser beams *B* reaching the non-facet area *RN.* Alternatively, the laser beams *B* are outputted onto the major surface of the ingot 2 so that the number of times the laser beams *B* are emitted to the facet area *RF* may be increased more than that the laser beams *B* are emitted to the non-facet area *RN.* More specifically, the frequency of emissions of the laser beam *B* onto the facet area *RF* may be increased to be higher than that onto the non-facet area *RN* or alternatively, the speed at which the laser beams *B* are swept on the face area *RF* may be decreased to be lower than on the non-facet area *RN* without changing the frequency of emission of the laser beams *B* to decrease an interval between adjacent emissions of the laser beams *B* in the scan direction *Ds*. It is preferable that the output power of the laser beams *B* reaching the facet area *RF* is about 1.5 times higher than that of the laser beams *B* reaching the non-facet area *RN.* It is also preferable that the interval between adjacent emissions of the laser beams *B* on the facet area *RF* in the scan direction *Ds* or the line feed direction *Df* is two-fifth of that on the non-facet area *RN* in the scan direction *Ds* or the line feed direction *Df.* The laser beams *B* may additionally be emitted to the facet area *RF* in addition to emission of the laser beam *B* to an overall area including the facet area *RF* and the non-facet area *RN.* In this case, a portion of the non-facet area *RN* which is located close to the facet area *RF* is also exposed to the laser beams *B*.

The separation layer formation step in this embodiment, as apparent from the above discussion, ensures the stability in forming the separation layer 25 in an overall region including the facet area RF and the non-facet area RN. Particularly, the formation of the separation layer 25 in the facet area RF is, like in the non-facet area RN, achieved without controlling adjustment of a distance in the z-axis direction between the light-concentrating device 42 from which the laser beams B are emitted and the chuck table 41 holding the ingot 2. This embodiment, therefore, enhances the production efficiency as compared with the prior art production methods.

Referring to Figs. 4A and 6, the separation layer formation step works to perform forward scans *Sc1* and return scans *Sc2.* The forward scans *Sc1* are to sweep the laser beams *B* to move the laser exposure positions *RP* onto which the laser beams *B* are omitted on the surface of the ingot 2 in the same direction as the off-angle direction *Dθ.* The return scans *Sc2* (which will also be referred to below as return laser scanning operations) are to sweep the laser beams *B* to move the laser exposure positions *PR* on the surface of the ingot 2 in a direction opposite to the off-angle direction *Dθ.* Therefore, in each of the forward scans *Scl,* the scan direction *Ds* is oriented in the same direction as the off-angle direction *Dθ*, while in each of the return scans *Sc2,* the scan direction *Ds* is oriented in a direction opposite to the off-angle direction *Dθ.* The forward scans Sc1 and the return scans Sc2 are performed alternately.

In an interval between completion of one of the forward scans *Sc1* and start of a subsequent one of the forward scans *Scl,* the position of the light-concentrating device 42 relative to the ingot 2 is shifted by a given distance in the line feed direction *Df.* However, in an interval between completion of one of the forward scans *Sc1* and start of an immediately following one of the return scans *Sc2,* the position of the light-concentrating device 42 relative to the ingot 2 in the in the line feed direction *Df* may be shifted or kept stationary. The same applies to an interval between completion of one of the return scans *Sc2* and start of a subsequent one of the forward scans *Sc1.* The distance by which the light-concentrating device 42 is moved relative to the ingot 2 in the line feed direction *Df* in each scan may be determined depending on conditions of emission of the laser beams *B*.

In each of the forward scans *Scl,* the laser beams *B* are outputted over an entire width of the ingot 2 in the scan direction *Ds*. In other words, each of the forward scans *Sc1* works to emit the laser beams *B* onto the major surface of the ingot 2 and shift the laser exposure positions *PR* on the surface of the ingot 2 in the scan direction *Ds* identical with the off-angle direction *Dθ*, thereby creating the scan lines *Ls* each of which extends in an entire region between ends of the major surface of the ingot 2 which are opposed to each other in the scan direction *Ds*. Each of the return scans *Sc2* may as well work to emit the laser beams *B* over the entire region between ends of the major surface of the ingot 2 which are opposed to each other in the scan direction *Ds*. Each of the return scans *Sc2* may alternatively emit the laser beams *B* only to a portion of the entire region between ends of the major surface of the ingot 2 which are opposed to each other in the scan direction *Ds.*

More specifically, each of the return scans *Sc2* (i.e., the return laser scanning operations) may emit the laser beams *B* only to and around the facet area *RF*. This enables the separation layer 25 to be formed successfully over an entire region including the facet area *RF* and the non-facet area *RN.* For instance, each of the return scans *Sc2* may work to emit the laser beams *B* only to either or both of the ends of the ingot 2 opposed to each other in the scan direction *Ds*. This causes each of the laser exposure positions *PR* to be moved on the surface of the ingot 2 in the scan direction *Ds* opposite the off-angle direction *Dθ* to form the scan lines *Ls* in either or both of the ends of the major surface of the ingot 2 which are opposed to each other in the scan direction *Ds*. This facilitates the ease with which the wafer precursor 26 starts being removed from the ingot 2 in the wafer separation step and improves the success rate of the wafer separation step. Each of the return scans *Sc2* may alternatively work to emit the laser beams *B* only to and around the facet area *RF* and the ends of the ingot 2 opposed to each other in the scan direction *Ds*.

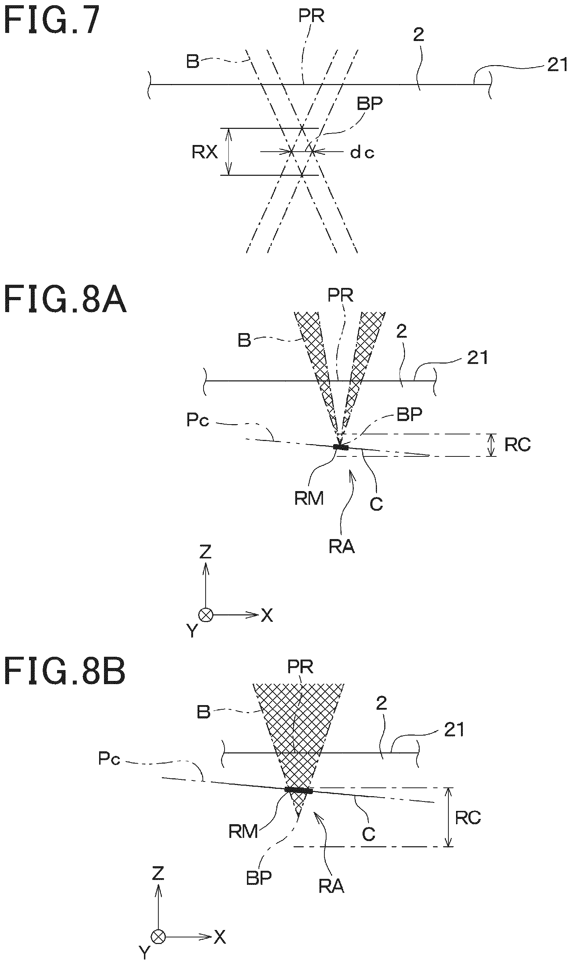

Each of the laser beams *B* used in this embodiment, as can be seen in Fig. 7, has a cross section spreading from the axial center to an outer edge thereof in a direction perpendicular to the length of the laser beam *B* (i.e., a radial direction). Each of the laser beams *B* has an intensity distribution where an outer peripheral portion of each of the laser beams *B* is higher in intensity than a central portion thereof. Specifically, each of the laser beams *B* becomes a ring-shape before reaching the focal point *BP* and then concentrates in the form of a dot at the focal point *BP.* Each of the laser beams *B,* therefore, has a minimum diameter *dc* at the focal point *BP.* The crossing range *RX* illustrated in Fig. 7 is a range which extends in the axial direction of each of the beams *B* around the focal point *BP* and where outer perimeters of a longitudinal section of a cone-shaped periphery (i.e., where the intensity is high) of each of the laser beams *B* cross each other, in other words, overlap each other.

As apparent from the above discussion, the separation layer-forming machine 40 is designed to emit the annular laser beams B to the laser beams B. Such a type of laser irradiator to output an annular or ring-shaped laser beam to a workpiece is taught in, for example, Japanese Patent First Publication Nos. 2006-130691 or 2014-147946, disclosures of which are entirely incorporated herein by reference.

Fig. 8A demonstrates how to create the laser exposure-reacted region *RA* in which the laser notches *RM* are formed using the annular laser beams *B* in this embodiment. Fig. 8B illustrates a comparative example of how to create the laser exposure-reacted region *RA* in which the laser notches *RM* are formed using the laser beams *B*.

Referring to Fig. 8B, use of the laser beam *B* which is solid having no empty space causes the laser notch *RM* that is a reformed region where *SiC* is dissociated into *Si* and *C* due to exposure to the laser beam *B* to appear at a depth different from that of the focal point *BP.* The depth of the laser exposure-reacted region *RA* in which the laser notch *RM* and the cracking *C* developing from the laser notch *RM* are produced by exposure to the laser beams *B* is, therefore, different from that of the focal point *BP.* For instance, the density of energy of the laser beam *B* may be increased to a level high enough to create the laser notch *RM* at a depth lower than that of the focal point *BP.* This causes the laser notch *RM* to appear at a depth lower than that of the focal point *BP.* The depth of the laser notch *RM* is usually changed depending on a variation in emitted energy of the laser beam *B,* index of refraction of the ingot 2, or optical system of the light-concentrating device 42. A region where there is a probability of occurrence of the laser notch *RM* is shown as the reformable region *RC* in Figs. 8A and 8B and corresponds to a reformed layer in the first patent literature which has been discussed above.

The use of the annular laser beam *B* illustrated in Fig. 8A causes the density of emitted energy thereof to be increased to a level high enough to create the laser notch *RM* only at a depth near the focal point *BP.* In other words, it is, unlike the solid laser beam *B* demonstrated in Fig. 8B, difficult for the annular laser beam *B* to increase the density of emitted energy thereof to a level required to create the laser notch *RM* at a depth shallower than that of the focal point *BP,* thereby ensuring the stability in producing the laser notch *RM* at a depth near the focal point *BP.* The use of the annular laser beam *B*, therefore, causes the reformable region *RC* to be delimited to a narrower depth region around the focal point *BP* than the solid laser beam *B.* This results in a decreased variation in depth at which the laser notches *RM* are created. In other words, the use of the annular laser beam *B* enables the separation layer 25 to be formed to have as small a thickness as possible, thereby resulting in a decrease in grinding or polishing allowance required for the separation layer 25. This embodiment is, therefore, capable of enhancing the efficiency in producing the wafer 1.

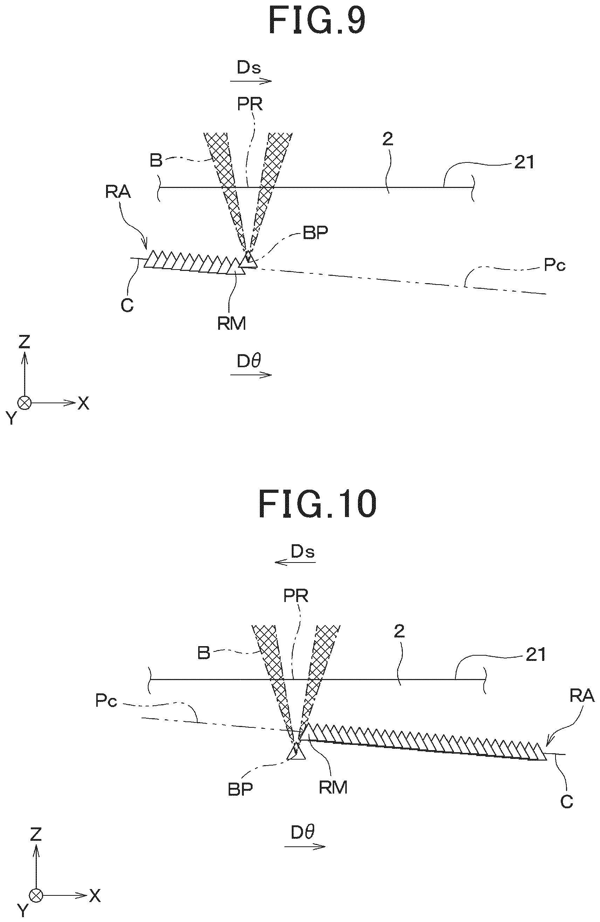

In the production method taught in the first patent literature discussed above, the laser scan direction is oriented perpendicular to a direction passing through the off-angle *θ* (i.e., the off-angle direction *Dθ* indicated in Fig. 1 or 3A). This results in instability in cleavage, thus leading to an increase in loss of wafer material. In contrast with the prior art, the scan direction *Ds* in which the laser beams B are swept in the ingot 2 is, as clearly illustrated in Fig. 4A, oriented parallel to the off-angle direction *Dθ.* The separation layer formation step, therefore, moves the laser exposure positions PR in the scan direction *Ds* along the off-angle direction *Dθ* in the laser scanning operation. In other words, the separation layer-forming machine 40 works to move the light-concentrating device 42 relative to the ingot 2 in the scan direction *Ds* parallel to the off-angle direction *Dθ* to sweep the laser beams *B,* thereby creating the scan lines *Ls* in the off-angle direction *Dθ.* This, as can be seen in Figs. 9 and 10, forms the laser notches *RM* and the cracking *C* along the (0001) surface *Pc*. This ensures the stability of cleavage of the separation layer 25 in the wafer separation step, thereby minimizing a loss of wafer material and also enabling the machining allowance or the time required in the wafer flattening step to be minimized, which enhance the efficiency of the wafer production method.

Fig. 9 demonstrates an example where the scan direction *Ds* is identical with the off-angle direction *Dθ.* Fig. 10 demonstrates an example where the scan direction *Ds* is opposite to the off-angle direction *Dθ.* In the example in Fig. 9, when the ingot 2 is, like in Fig. 4A, placed with the ingot *C*-surface 21 facing upward, the laser exposure positions *PR* are moved in the laser scanning operation diagonally from the high height side to the low height side of the (0001) surface *Pc*. In the example in Fig. 10, when the ingot 2 is placed with the ingot *C*-surface 21 facing upward, the laser exposure positions *PR* are moved in the laser scanning operation diagonally from the low height side to the high height side of the (0001) surface *Pc*.

Assuming that there is still no laser-exposure reacted region *RA*, in other words, there is still no laser notches *RM* or cracking *C* around the laser exposure positions *PR* in the in-plane direction, emission of the laser beams *B* to the ingot 2 will facilitate the formation of the laser notches *RM* at a depth near the focal points *BP,* but however, the laser beams *B* are actually swept in the scan direction *Ds* while sequentially creating the laser notches *RM* and the cracking *C*. Such a condition is usually encountered when the first laser scanning operation is performed to create the laser notches *RM* at start points of the scan lines *Ls.* Accordingly, most of the laser scanning operations will create the laser exposure-reacted region *RA* around the laser exposure positions *PR* in the in-plane direction.

One of the laser exposure positions *PR* which is developed in the second or subsequent laser scanning operation, as demonstrated in Fig. 9 or 10, usually follows the laser exposure-reacted region *RA* (will also be referred to as a preceding laser exposure-reacted region) which has been already created immediately before. This will cause the preceding laser exposure-reacted region *RA* to have an increased rate of absorption of the laser beam *B*. The preceding laser exposure-reacted region *RA* is successively created on the (0001) surface *Pc*, thereby facilitating the ease with which the laser notches *RM* are developed sequentially in the (0001) surface Pc in the laser scanning operations.

In the example in Fig. 9, the laser notches RM are, as described above, developed sequentially in the scan direction *Ds* in the (0001) surface *Pc* in the laser scanning operations. The laser notches RM have depths increasing as they are sequentially produced in the scan direction *Ds*. The laser notches *RM* are, therefore, sequentially arranged away the focal points *BP.* This leads to a risk that a portion of the ingot 2 which is located at a depth substantially equal to that of the immediately produced laser notch *RM* may have a density of emitted energy of the laser beam *B* which is not elevated to a level high enough to newly create the laser notch *RM*, thereby resulting in a failure in developing the laser notches *RM* additionally in the (0001) surface *Pc*. A later one of the laser notches *RM* is, therefore, as illustrated in Fig. 9, formed at a depth near the focal point *BP* of a later emitted one of the laser beams *B*, thereby causing preceding and following ones of the laser notches *RM* to have levels (i.e., depths) different from each other.

In the example in Fig. 10, the laser notches *RM* which are developed sequentially in the (0001) surface *Pc* have depths, unlike in the example in Fig. 9, decreasing as they are sequentially produced in the scan direction *Ds*. The laser notches *RM* are, therefore, sequentially arranged away the focal points *BP.* When a portion of the ingot 2 which is located at a depth substantially equal to that of the immediately produced laser notch *RM* has a density of emitted energy of the laser beam *B* which is not elevated to a level high enough to newly create the laser notch *RM*, it will result in a failure in developing the laser notches *RM* additionally in the (0001) surface *Pc*. A later one of the laser notches *RM* is, therefore, as illustrated in Fig. 10, formed at a depth near the focal point *BP* of a later emitted one of the laser beams *B.* A direction in which the laser notches *RM* are sequentially developed in the example in Fig. 10 is different from that in the example in Fig. 9, that is, a direction toward a light source of the laser beams *B*, i.e., close to the laser-emitted surface of the ingot 2, thereby facilitating an array of the sequentially produced laser notches *RM* having a length longer than that in the example in Fig. 9. This, as can be seen in Fig. 10, results in an increased different in level between preceding and following ones of the laser notches *RM* as compared with the example in Fig. 9.

As apparent from the above discussion, a decrease in level or step between preceding and following ones of the laser notches *RM* may be achieved in the laser scanning operations by moving the laser exposure positions *PR* from the high height side to the low height side of the *C*-surface of the ingot 2 in the scan direction *Ds* oriented in the off-angle direction *Dθ.* This enables the separation layer 25 to have a minimized thickness, thereby enabling the grinding or polishing allowance required for the separation layer 25. This enhances the efficiency of the wafer production method.

### WAFER SEPARATION STEP

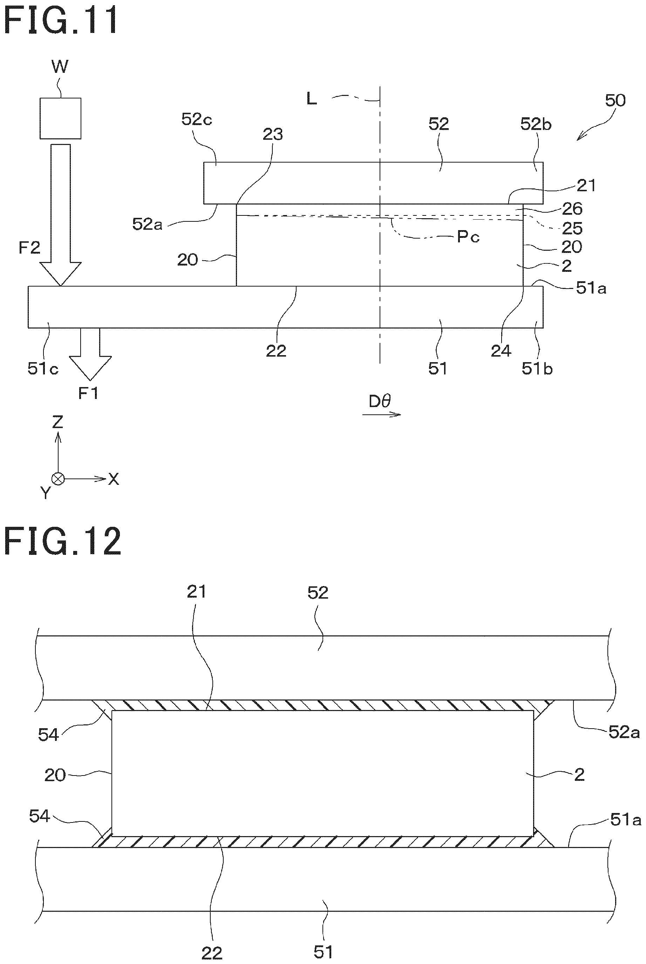

Fig. 11 illustrates the wafer separation step and the separating machine 50 used in the wafer separation step. The right-handed *X-Y-Z* coordinate system in Fig. 11 is shown to match that illustrated in Fig. 1.

The separating machine 50 is configured to exert mechanical load or pressure on the first end 23 that of one of ends of the ingot 2 which are opposed to each other in the in-plane direction parallel to the ingot *C*-surface 21, i.e., the off-angle direction *Dθ* to separate the wafer precursor 26 from the ingot 2 at the separation layer 25. The first end 23 is the end of the ingot 2 which is located at the higher side of the off-angle, that is, a higher-level side of the *C*-surface (i.e., the (0001) surface *Pc*) of the ingot 2 placed with the ingot *C*-surface 21 facing upward. The separating machine 50 in this embodiment is designed to apply a static and/or a dynamic mechanical load, as oriented in the z-axis direction in the drawing, on the ingot 2 to draw the ingot *C*-surface 21 away from the ingot *Si*-surface 22 at the first end 23. The separating machine 50 includes the holding table 51, the separator pad 52, and the drive member 53.

The holding table 51 supports the ingot 2 from below it. Specifically, the holding table 51 has an upper surface serving as the holding surface 51a which is joined to the bottom surface (i.e., the ingot *Si*-surface 22) of the ingot 2 through adhesive, such as wax. The holding table 51 has the first table end 51b and the second table end 51c which are opposed to each other in the off-angle direction *Dθ.* The second table end 51c (i.e., the left end of the holding table 51, as viewed in Fig. 11) has the table base surface 51d which is inclined obliquely upward in the off-angle direction *Dθ.* In other words, the holding table 51 is, as clearly illustrated in Fig. 11, of a trapezoid shape which has an upper side and a lower side which is longer than the upper side.

The separator pad 52 is located above the holding table 51 and movable close to or away from the holding table 51 in the z-axis direction in the drawing. In other words, the separating machine 50 is designed to have the holding table 51 and the separator pad 52 which are movable relative to each other in the height direction of the ingot 2. The separator pad 52 has a bottom surface serving as the retaining surface 52a which is joined through adhesive, such as wax, to the ingot *C*-surface 21 that is the top surface of the ingot 2. The separator pad 52 has ends opposed to each other in the off-angle direction *Dθ* which will also be referred to as the first pad end 52b and the second pad end 52c. The second pad end 52c facing left, as viewed in the drawing, in the off-angle direction *Dθ* has the pad end surface 52d. The pad end surface 52d is inclined obliquely to extend downward in the off-angle direction *Dθ.* In other words, the separator pad 52 is, as can be seen in Fig. 11, of a trapezoidal shape in a lateral view with an upper side and a lower side shorter than the upper side. The pad end surface 52d is located to face the table base surface 51d in the vertical direction, in other words, arranged just above the table base surface 51d. The ingot *C*-surface 21 is retained by the separator pad 52, while the ingot *Si*-surface 22 is retained by the holding table 51, thereby firmly holding the ingot 2 between the holding table 51 and the separator pad 52. This will also be referred to below as an ingot-held state.

In the ingot-held state, the drive member 53 works to apply a mechanical pressure to at least one of the holding table 51 and the separator pad 52 to move the holding table 51 and the separator pad 52 relative to each other in the heigh direction of the ingot 2. Specifically, the drive member 53 has the first driving end surface 53a and the second driving end surface 53b. The first driving end surface 53a is inclined obliquely to extend downward in the off-angle direction *Dθ.* In other words, the first driving end surface 53a extends parallel to the pad end surface 52d. The second driving end surface 53b is inclined obliquely to extend upward in the off-angle direction *Dθ.* In other words, the second driving end surface 53b extends parallel to the table base surface 51d. In the ingot-held state, the drive member 53 is arranged with the first driving end surface 53a contacting with the pad end surface 52d and the second driving end surface 53b contacting with the table base surface 51d. The drive member 53 is, as can be seen in Fig. 11, of a shape defined in a lateral view by rotating a trapezoid with a lower side and an upper side longer than the lower side in a clockwise direction by 90 degrees. The drive member 53 is moved by an actuator, not shown, upward in the height direction of the ingot 2 and/or in the off-angle direction *Dθ* toward the ingot 2. The movement of the drive member 53 in the upward direction and/or in the off-angle direction *Dθ* exerts a moment on the ingot 2 where the second pad end 52c acts as a point of effort *FP,* and the first end 23 acts as a point of pivot *PP* and a point of action *WP.*

The wafer separation step in which the wafer precursor 26 is removed from the ingot 2 (which will also be simply referred to as wafer separation) includes a table retaining step, a holding step, and a separation pressure applying step. The table retaining step is to join the ingot Si-surface 22 to the holding surface 51a to firmly secure the ingot 2 to the holding table 51. The holding step is to join the ingot *C*-surface 21 to the retaining surface 52a to firmly secure the ingot 2 to the separator pad 52 to achieve the ingot-held state. The separation pressure applying step is performed in the ingot-held state to apply a static or dynamic mechanical load to the point of effort *FP* that is the second pad end 52c of the separator pad 52 to exert a moment on the ingot 2 where the first end 23 acts as the point of pivot *PP* and the point of action *WP.* Specifically, the separation pressure applying step works in the ingot-held state as a pressing step to move the drive member 53 in the upward direction and/or in the off-angle direction *Dθ* to press the second pad end 52c upward in the height direction of the ingot 2. This causes the wafer precursor 26 that is a part of the ingot 2 to be separated from the ingot 2 at the separation layer 25.

As apparent from the above discussion, the wafer separation step in this embodiment works to exert a mechanical pressure on the first end 23 of the ingot 2 in a single direction. The first end 23 is one of the ends of the ingot 2 which are opposed to each other in the in-plane direction parallel to the top surface (i.e., the ingot *C*-surface 21 in the example shown in Fig. 11) of the ingot 2. This exerts a moment on the ingot 2 where the first end 23 acts as the point of pivot *PP* and the point of action *WP.*

In the wafer separation step, as taught in Japanese Patent No. 6678522, the point of action *WP* and the point of pivot *PP* are provided within the ingot 2, in other words, inside an outer edge of the separation layer 25 in the in-plane direction thereof. This structure requires a higher pressure to develop the wafer separation at the separation layer 25 than in this embodiment. The pressure is exerted on a wide area of the separation layer 25, thereby resulting in a variation in location where cracks are created to initiate the wafer separation. This leads to a risk of creation of unseparated portion(s) of the ingot or breakage of the separated wafer and also faces a problem that the separated wafer may have a rough surface, thus resulting in an increase in grinding or polishing allowance of the wafer. The wafer production method taught in the first patent literature described above usually produces a variation in location where the wafer is sliced or separated from the ingot upon induction of cleavage due to ultrasonic vibration. This creates a step(s) on the surface of the surface of the separated wafer, thereby requiring an increase in grinding or polishing allowance of the wafer or resulting in a failure in separating the wafer.

The wafer separation step in this embodiment is designed to exert a mechanical load in a single direction on one of the ends of the ingot 2 which are opposed to each other in the off-angle direction *Dθ* to cut off the wafer precursor 26 from the ingot 2 at the separation layer 25. In other words, the mechanical load is concentrated on one of ends of the separation layer 25 which are opposed to each other in the off-angle direction *Dθ.* This exerts a moment on the ingot 2 where the load-exerted end of the separation layer 25 acts as the point of pivot *PP* and the point of action *WP.* This causes the separation to be initiated from a crack(s) formed in one of the ends of the ingot 2 which are opposed to each other in the off-angle direction *Dθ.* This enables the mechanical load applied to the ingot 2 to be decreased gradually to ensure the stability in promoting or facilitating fracture in the whole of the separation layer 25, thereby minimizing the roughness of the separated surface 32 of the removed object 30 or the ingot *C*-surface 21 which usually occurs after the object 30 is separated from the body of the ingot 2. Particularly, the continuous fracture is achieved by selecting or setting the first end 23 that is a point where the fracture is initiated to the higher side of the off-angle defined in the off-angle direction *Dθ* in this embodiment, thereby enhancing the stability in occurrence of the cleavage. This minimizes a rate of occurrence of defects in the wafer separation step and reduces the grinding or polishing allowance of the removed object 30 required after completion of the wafer separation step. The wafer production method in this embodiment is, therefore, capable of providing a higher production efficiency than in the prior art production methods.

### MODIFICATIONS

This disclosure is not limited to the first embodiment as described above. The first embodiment may be modified in the following ways. Some of possible modifications will be described below only in terms of parts different from those in the first embodiment. In the following discussion, the same or similar reference numbers refer to the same or similar parts as in the first embodiment, and explanation thereof in detail will be omitted here.

The wafer 1, i.e., the ingot 2 may be designed to have a shape or configuration (e.g., an outer diameter or a planar shape) different from that in the first embodiment. The ingot 2 may be shaped to or not to have an orientation flat.

The value of the off-angle *θ* may be selected as needed. The wafer *C*-surface 11 or the ingot *C*-surface 21 in the above embodiment is not identical with the *C*-surface, that is, the (0001) surface *Pc* crystallographically defined in the strict sense. The term "*C*-surface" is, however, generally referred to in this field of wafer production, and thus used in this disclosure. The same is true for the *Si*-surface. Of course, the wafer *C*-surface 11 or the ingot *C*-surface 21 referred to in this disclosure may exactly match the *C*-surface or the (0001) surface *Pc*. Similarly, the wafer *Si*-surface 12 or the ingot *Si*-surface 22 may be exactly identical with the crystallographically defined *Si*-surface. In other words, the off-angle *θ* may be selected to be zero degrees.

There is a probability that the separated surface 32 may have a surface condition or an edge condition which enables the separated surface 32 to be ground or polished in the ECMG or ECMP operation to a required level depending upon a condition of emission of the laser beams *B* or a laser scanning condition. The grinding step or polishing step for the separated surface 32 illustrated in Fig. 2 may, therefore, be omitted as needed. The same applies to the rough-grinding of the ingot 2 performed after completion of the wafer separation step.

Figs. 4A and 4B schematically illustrate the structure of the separation layer-forming machine 40 for the sake of simplicity of explanation of the separation layer formation step. The separation layer-forming machine 40 actually used is not necessarily identical in structure with that illustrated in Fig. 4A or 4B. For instance, the positive z-axis direction indicated in Fig. 4A or 4B is usually defined to be identical with the vertical direction, but however, it may be oriented horizontally. In this case, the surface of the ingot 2 expose to the laser beams *B* may not be the top or upper surface thereof. The chuck table 41 may be designed to hold or retain the ingot 2 without use of a vacuum mechanism using air pressure.

The separation layer-forming machine 40 in the first embodiment is designed to have the chuck table 41 on which the ingot 2 is retained and which is movable at least in the in-plane direction. The separation layer-forming machine 40 also has the light-concentrating device 42 arranged to be stationary in the in-plane direction. The separation layer-forming machine 40 may, however, be designed to have the chuck table 41 stationary in the in-plane direction and the light-concentrating device 42 movable in the in-plane direction using a scanning device, not shown. For instance, the separation layer-forming machine 40 may be equipped with a scanning device working to move the focal points *BP* of the laser beams *B* relative to the ingot 2 in the *x*-, *y*-, and *z*-axis directions indicated in the drawings. An interval between the light-concentrating device 42 and the chuck table 41 may be controlled in the z-axis direction between the facet area *RF* and the non-facet area *RN* or regardless thereof. The separation layer-forming machine 40 actually used may be configured to have a modification of the structure illustrated in Fig. 4A or 4B.

Fig. 11 illustrates the separating machine 50 schematically for the sake of simplicity of explanation of the wafer separation step. The structure of the separating machine 50 actually used is not necessarily identical with that in Fig. 11. For instance, the positive *z*-axis direction indicated in Fig. 11 is usually defined to be identical with the vertical direction, but however, it may be oriented horizontally. The separating machine 50 illustrated in Fig. 11 may be modified in the following ways.

When the level of mechanical load applied to the ingot 2 is much higher than that only required to achieve the wafer separation, it may produce cracking in the wafer precursor 26 in the wafer separation step. A variation in cleavage of the ingot 2 or a non-uniformity of material of the ingot 2 will usually result in a variation in mechanical load or pressure required to achieve the wafer separation. If is preferable in the wafer separation step to continuously or successively (i.e., intermittently) raise the level of the mechanical load exerted on the ingot 2 until the wafer separation is initiated. In other words, the generation of cracking may be minimized by gradually elevating the mechanical load applied to the ingot 2 and stopping it until the wafer separation is initiated to minimize a deviation of a mechanical load required by the wafer separation from that actually applied to the ingot 2.

The continuous application of a constant level of mechanical load to the ingot 2 has a risk that the mechanical load may not concentrate on the end of the ingot 2 to a required degree. The use of an impact load (i.e., a dynamic load) ensures the stability in concentrating it on the end of the ingot 2, but it leads to a risk that the removal of the wafer precursor 26 from the ingot 2 at the separation layer 25 may not be completed. In such a case, re-application of impact load to the ingot 2 may result in breakage of the wafer precursor 26. In order to eliminate such a drawback, it is preferable in the wafer separation step to use both static and impact loads applied to the ingot 2. Specifically, the static load F1 is, as illustrated in Fig. 12, applied to the holding table 51. The weight *W* is additionally dropped on the second table end 51c of the holding table 51 to exert the impact load *F2* on the holding table 51 in addition to the static load *F1.* This ensures the stability in applying a level of pressure to the end of the ingot 2 which is required to achieve the wafer separation. Even when the impact load *F2* fails to complete the wafer separation (i.e., the separation of the wafer precursor 26 from the ingot 2), the wafer separation may be accomplished fully by continuously applying a constant level of the static load *F1* to the ingot 2.

The retaining of the ingot 2 in the wafer separation step may be achieved in another way using, for example, air pressure. For instance, the holding table 51 may be designed to have a plurality of vacuum holes, not shown, which open at the holding surface 51a and suck the ingot Si-surface 22 to the holding surface 51a using negative pressure. Similarly, the separator pad 52 may be designed to have a plurality of vacuum holes, not shown, which open at the retaining surface 52a and suck the ingot *C*-surface 21 to the retaining surface 52a using negative pressure.

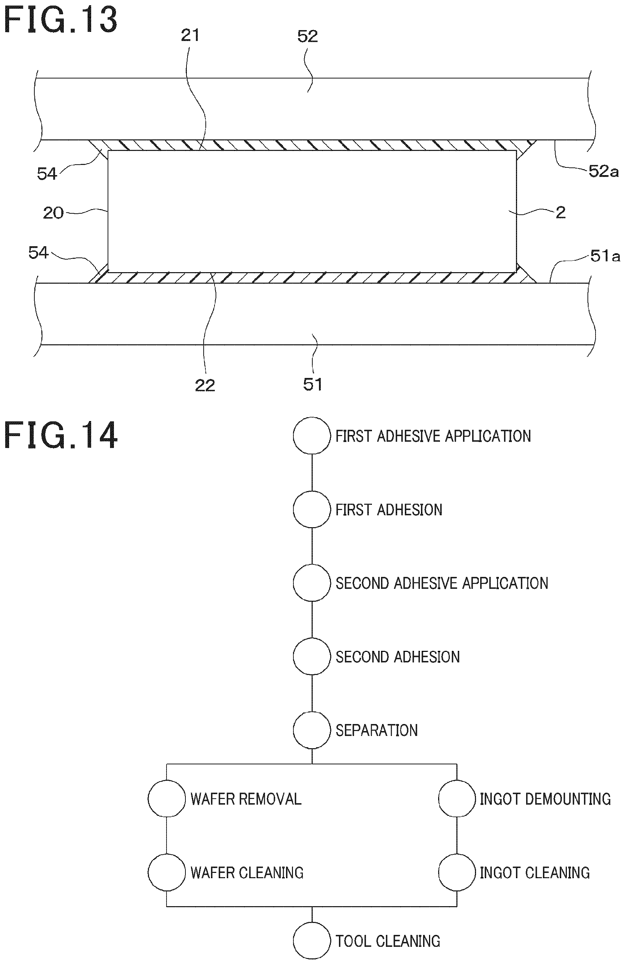

Given the strength of the separating machine 50 against the mechanical load required for the wafer separation or cost of the separating machine 50, the retaining of the ingot 2 in the wafer separation step is preferably achieved, as shown in Fig. 13, using the adhesive 54, such as wax. Specifically, the wafer separation step is preferably achieved in the following steps:
a first step of joining the ingot-*C*-surface 21 that is the top surface of the ingot 2 to the separator pad 52 serving as a top surface-retaining member using the adhesive 54,
a second step of joining the ingot *Si*-surface 22 that is the bottom surface of the ingot 2 to the holding table 51 serving as a bottom surface-retaining member using the adhesive 54, and
a third step of applying mechanical load to the holding table 51 and/or the separator pad 52.

It is, as shown in Fig. 13, advisable that the adhesive 54 be spread outside the ingot-side surfaces 20 extending between the ingot *C*-surface 21 and the ingot *Si*-surface 22 until the adhesive 54 sticks to the ingot-side surface 20. The use of the adhesive 54 spreading over the ingot-side surface 20 enhances the retention of the ingot 2.

When the adhesive 54 is used, it is necessary to make the thickness of a layer of a joint of the adhesive 54 and the ingot 2 uniform. The entry of air bubbles in the layer of joint may result in defects occurring in the wafer separation step. Specifically, when the impact is applied to the ingot 2 to achieve wafer separation with the layer of joint containing air bubbles, it may cause potions of the layer of joint which are insufficiently glued to the ingot 2 and/or a separating mechanism (e.g., the separating machine 50) to fail to tear cleanly, which leads to breakage of the wafer precursor 26. In order to alleviate such a drawback, it is preferable to arrange the adhesive 54 inside the outer periphery of the ingot 2 and then spread it using thermal energy or mechanical pressure. This results in uniformity of the thickness of the layer of joint created by the adhesive 54 and minimizes a risk of entry of air bubbles in the joint layer.

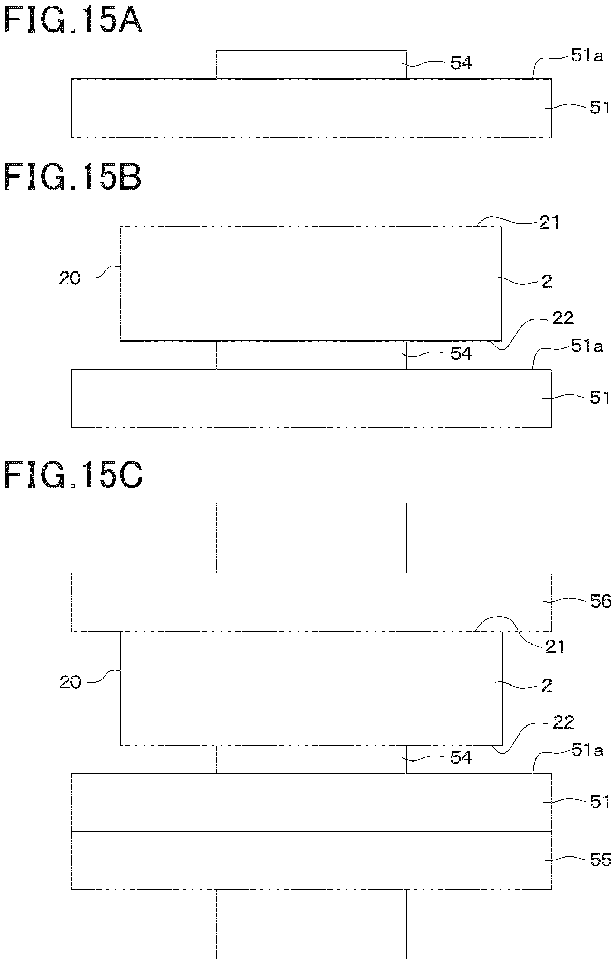

Fig. 14 illustrates a sequence of operations in the wafer separation step using the adhesive 54 to retain the ingot 2. Figs. 15A to 15H schematically demonstrate processes to spread the adhesive 54 using thermal energy or mechanical pressure to achieve a joint of the ingot 2 to the holding table 51 and the separator pad 52. The wafer separation step will be described below in detail with reference to Figs. 14 and 15A to 15H.

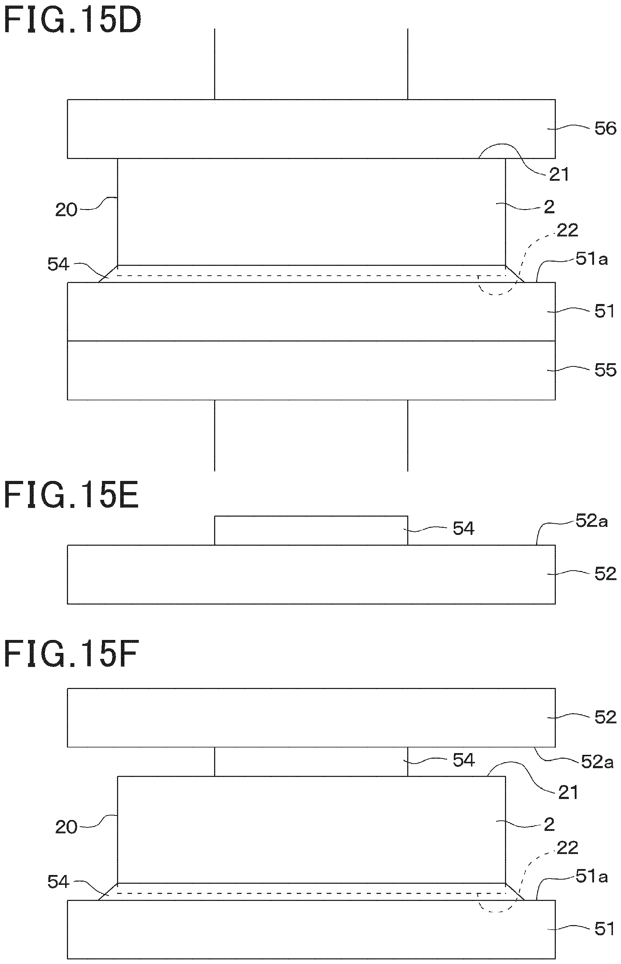

First, the adhesive 54 is, as illustrated in Fig. 15A, applied to the holding surface 51a that is an upper surface of the holding table 51. Specifically, the adhesive 54 prepared in the form of a tablet is placed on the holding surface 51a. The adhesive 54 is located inside the outer periphery of the ingot 2. The holding table 51 is preferably heated. Subsequently, the ingot 2 is, as illustrated in Fig. 15B, arranged on the adhesive 54. The adhesive 54 is located inside the outer periphery of the ingot 2. The ingot 2 is then preferably heated or may alternatively be heated before placed on the adhesive 54. This creates a stack of the holding table 51, the adhesive 54, and the ingot 2. The stack is, as illustrated in Fig. 15C, then mounted between the lower press die 55 and the upper press die 56. The pressure is applied to the stack between the lower press die 55 and the upper press die 56. The stack is preferably heated at the same time when pressed or may alternatively be heated before pressed. This causes the adhesive 54, as illustrated in Fig. 15D, to spread outside the ingot-side surface 20 with aid of the thermal energy and the mechanical pressure, thereby achieving a firm joint of the ingot 2 and the holding table 51.

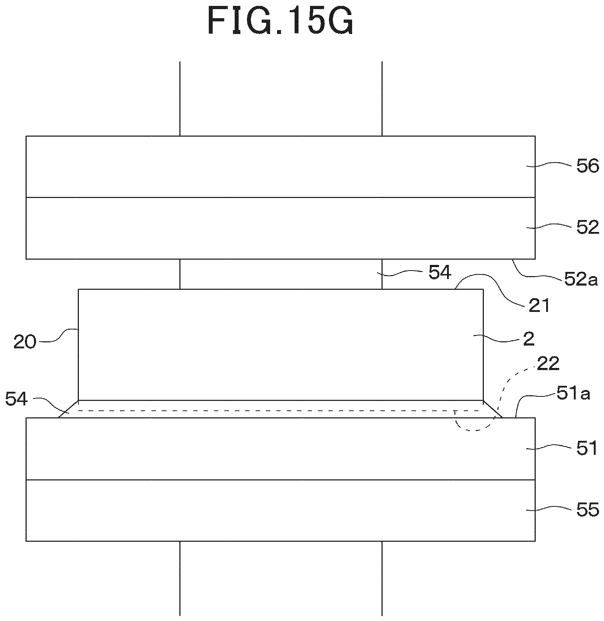

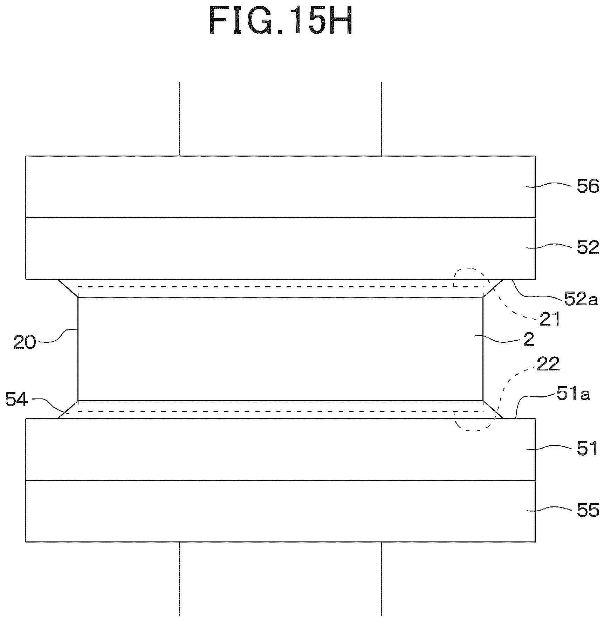

The adhesion between the ingot 2 and the separator pad 52 is achieved in the same way as described above. Specifically, the adhesive 54 is, as illustrated in Fig. 15E, applied to the retaining surface 52a that is a bottom surface of the separator pad 52. The size of an area of the separator pad 52 to which the adhesive 54 is applied is identical with that to which the adhesive 54 is applied to the holding table 51. The separator pad 52 is preferably heated or may alternatively be heated before the adhesive 54 is applied to the separator pad 52. Subsequently, the separator pad 52 is, as illustrated in Fig. 15F, mounted on a joint assembly of the ingot 2 and the holding table 51 with the retaining surface 52a to which the adhesive 54 is applied facing the ingot 2, thereby creating a stack of the ingot 2, the holding table 51, the separator pad 52, and the adhesive 54. The stack is, as illustrated in Fig. 15G, then arranged between the lower press die 55 and the upper press die 56. The pressure is applied to the stack held between the lower press die 55 and the upper press die 56. The stack is preferably heated at the same time when pressed or may alternatively be heated before pressed. This causes the adhesive 54, as illustrated in Fig. 15H, to spread outside the ingot-side surface 20 with aid of the thermal energy and the mechanical pressure, thereby achieving a firm joint of the ingot 2 and the separator pad 52.

Referring back to Fig. 14, after the two adhesion steps are completed in the above way, a mechanical load is applied to the holding table 51 and/or the separator pad 52 to initiate the wafer separation. Subsequently, the removed object 30 still adhered to the separator pad 52 is heated and removed from the separator pad 52. The removed object 30 is subjected to rough-cleaning and finishing-cleaning using ethanol and ultrasonic wave and then rinsed in purified water. Similarly, the ingot 2 still adhered to the holding table 51 is heated and removed from the holding table 51. The ingot 2 is subjected to rough-cleaning and finishing-cleaning using ethanol and ultrasonic wave and then rinsed in purified water. The holding table 51 and the separator pad 52 are also subjected to rough-cleaning and finishing-cleaning using ethanol and ultrasonic waves and then rinsed in purified water.

The holding table 51 illustrated in Figs. 15A to 15H may have a portion designed to play a role as a fastener achieving a joint to the ingot 2. For instance, the joint of the ingot 2 and the holding table 51 may be achieved by adhering the ingot 2 to the fastener in the same way as described above and then securing the fastener to the body of the holding table 51 using screws. The same applies to the separator pad 52.

In the above embodiment, the separation layer 25 is formed in the ingot *C*-surface 21 using *C*-surface laser emission techniques in which the laser beams *B* are emitted to the ingot *C*-surface 21, but however, the separation layer 25 may alternatively be formed in the ingot *Si*-surface 22 using Si-surface laser emission techniques in which the laser beams *B* are emitted to the ingot *Si*-surface 22. In this case, the separation pad 52 of the separating machine 50 illustrated in Fig. 11 is joined to the ingot *Si*-surface 22. The wafer separation step is, therefore, performed with the ingot *Si-*surface 22 facing upward.

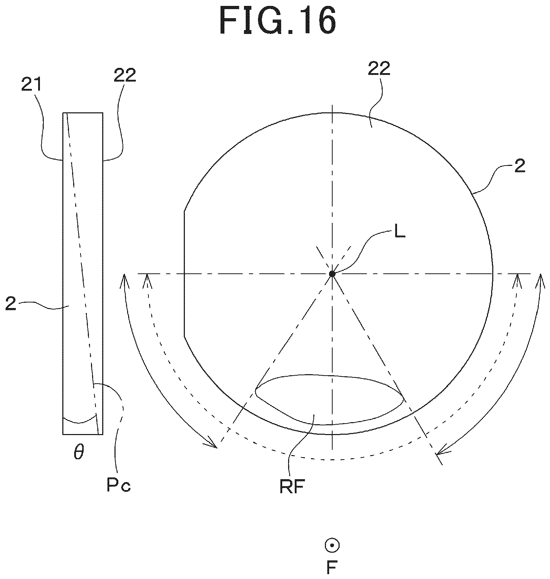

When the wafer separation step is performed with the ingot 2 oriented to have the ingot *Si*-surface 22 (i.e., the upper surface) facing upward, the facet area *RF* is, as illustrated in Fig. 16, located at the high-level side, that is, the higher-side, as indicated by a broken line, of the off-angle on the (0001) surface *Pc*. This layout results in an increase in resistance to occurrence of the cleavage in or around the facet area *RF*, which may result in a failure in the cleavage extending to the end of the ingot 2. This, therefore, needs to be considered in the wafer separation step. In order to mitigate such a drawback, the wafer separation step is preferably performed to apply the wafer-separation inducing load *F* to areas, as indicated by arc-shaped solid lines in the drawing, which do not overlap the facet area *RF* in a circumferential direction around the central axis *L*. The wafer-separation inducing load *F* is oriented to press the ingot *Si*-surface 22 upward, in other words, urge the ingot *Si*-surface 22 away from the ingot *C*-surface 21. In this way, the wafer separation is achieved by applying mechanical load to an area of the ingot 2 other than the face area RF on higher side of the off-angle, thereby ensuring the completion of separation of the wafer precursor 26 from the ingot 2 using the *Si*-surface laser emission techniques.

The component parts described in the above embodiment are not necessarily essential unless otherwise specified or viewed to be essential in principle. When the number of the component parts, a numerical number, a volume, or a range is referred to in the above discussion, this disclosure is not limited to it unless otherwise specified or viewed to be essential in principal. Similarly, when the shape of, the orientation of, or the positional relation among the component parts is referred to in the above discussion, this disclosure is not limited to it unless otherwise specified or viewed to be essential in principal.

This disclosure is not limited to the above embodiment and the modifications, but may be realized by various embodiments without departing from the purpose of the disclosure. This disclosure includes all possible combinations of the features of the above embodiment and the modifications or features similar to the parts of the above embodiment and the modifications. The structures in this disclosure may include only one or some of the features discussed in the above embodiments unless otherwise inconsistent with aspects of this disclosure.

## Claims

1. A wafer production method for separating a wafer (1) from an ingot (2) which is made from single-crystal *SiC* and has a *c*-axis and a *C*-surface which extend perpendicular to each other, comprising:
a separation layer formation step of emitting a laser beam to a top surface (21) that is one of end surfaces of the ingot opposed to each other in height direction of the ingot to form a separation layer (25) at a depth from the top surface of the ingot which corresponds to a thickness of the wafer, the ingot having a given degree of transmittance to the laser beam;
a wafer separation step of separating a wafer precursor (26) from the ingot at the separation layer, the wafer precursor being created by a portion of the ingot between the top surface and the separation layer;
a wafer flattening step of flattening a major surface (32) of a plate-like removed object (30) derived in the wafer separation step, wherein
the c-axis of the ingot is oriented to be inclined in an off-angle direction (*Dθ*) at an off-angle (*θ*) from a central axis (*L*) which is defined to extend perpendicular to the top surface, the off-angle being greater than zero degrees, and
separation of the wafer precursor from the ingot is achieved by applying a physical load in a single direction to a first end (23) that is one of ends of the ingot which are opposed to each other in the off-angle direction.

2. The wafer production method as set forth in claim 1, wherein the first end of the ingot is located on a high-level side of the ingot when the ingot is oriented to have the top surface facing upward.

3. The wafer production method as set forth in claim 1 or 2, wherein formation of the separation layer is achieved with a facet area (*RF*) of the ingot located at a low height side of the *C*-surface when the ingot is oriented to have the top surface facing upward.

4. The wafer production method as set forth in claim 1 or 2, wherein the separation of the wafer precursor is achieved by applying the physical load to an area of the ingot which does not overlap the facet area in a circumferential direction around the central axis where the top surface of the ingot defines a Si-surface thereof, the ingot is oriented to have the top surface facing upward, and the facet area is located at a high height side of the *C*-surface.

5. The wafer production method as set forth in any one of claims 1 to 3, wherein the separation layer formation step is to perform a laser scanning operation a plurality of times in which the laser beam is emitted to the top surface and swept to move a laser exposure position (*PR*) where a portion of the top surface is exposed to the laser beam in a first direction (*Ds*) along the top surface,
the separation layer forming step steers the laser beam in a second direction (*Df*) which is oriented perpendicular to the first direction along the top surface in each of the laser scanning operations, thereby developing a plurality of scan lines (*Ls*) which are defined by laser notches and each of which extends in the first direction to form the separation layer, the scan lines being arranged adjacent each other in the second direction,
each of the scan lines is created by sweeping the laser beam to move the laser exposure position in the first direction so that each of the scan lines extends in an entire region between ends of the top surface which are opposed to each other in the first direction,
the laser scanning operations include a return laser scanning operation which sweeps the laser beam to move the laser exposure position in a direction opposite the first direction to create at least one of the laser notches in at least one of ends of the top surface which are opposed to each other in the first direction.

6. The wafer production method as set forth in any one of claims 1 to 5, wherein the separation of the wafer precursor is performed by continuously or intermittently raising a level of the load exerted on the ingot.

7. The wafer production method as set forth in any one of claims 1 to 6, wherein the wafer separation step includes;
joining the top surface of the ingot and a top surface-retaining member (52) together;
joining a bottom surface (22) that is an end surface of the ingot opposed to the top surface in a height direction of the ingot to a bottom surface-retaining member (51); and
applying the load to the top surface-retaining member and/or the bottom surface-retaining member, wherein
each of the joining of the top surface and the top surface-retaining member and the joining of the bottom surface and the bottom surface-retaining member is achieved by placing adhesive (54) inside an outer periphery of the ingot and then spreading the adhesive using thermal energy and/or mechanical pressure.

8. The wafer production method as set forth in claim 7, wherein in each of the joining of the top surface and the top surface-retaining member and the joining of the bottom surface and the bottom surface-retaining member, the adhesive is spread outside a side surface (20) of the ingot which extends between the top surface and the bottom surface of the ingot until the adhesive sticks to the side surface.

9. The wafer production method as set forth in any one of claims 1 to 8, wherein the separation of the wafer precursor is achieved by applying both static pressure and dynamic pressure to the ingot.
